Europäisches Patentamt

European Patent Office

Office européen des brevets

(19)

(11) Publication number: **0 052 786**
A1

# EUROPEAN PATENT APPLICATION

(12)

(21) Application number: 81108982.0

(22) Date of filing: 27.10.81

(51) Int. Cl.³: **C 23 G 1/00**
C 23 G 1/02, C 23 G 5/02
//H01L21/306, C11D1/00

(30) Priority: 25.11.80 US 210435

(43) Date of publication of application:
02.06.82 Bulletin 82/22

(84) Designated Contracting States:
DE FR GB

(71) Applicant: International Business Machines
Corporation
Armonk, N.Y. 10504(US)

(72) Inventor: Block, Murry Leo
53 Dunder Road
Burlington Vermont 05401(US)

(72) Inventor: Clark, Roger James
RD No. 2, P.O. Box 540
Underhill Vermont 05489(US)

(72) Inventor: Gartland, Karl Eric
70 Meridian Street
Malden Massachusetts 02148(US)

(72) Inventor: Kennison, Robert Ellis
P.O. Box 106
Essex Vermont 05451(US)

(74) Representative: Kreidler, Eva-Maria, Dr. rer. nat.
Schönaicher Strasse 220
D-7030 Böblingen(DE)

(54) Method for removing grease from surfaces.

(57) An improved solvent system for removing grease from surfaces, especially bentonite filled grease is disclosed. The solvent system comprises from about 90% to about 50% by weight of a substituted or unsubstituted hydrocarbon solvent, and from about 10% to about 50% by weight of an unsaturated fatty acid. Substituted aromatic hydrocarbons are preferred with toluene being the solvent of choice, and oleic acid at a concentration of about 30% is the unsaturated fatty acid of choice.

EP 0 052 786 A1

- 1 -

## METHOD FOR REMOVING GREASE FROM SURFACES

This invention relates generally to a method for removing grease and more particularly to an improved method for removing petroleum based greases, especially such greases containing fillers such as bentonite.

Various types of greases, especially petroleum based greases containing fillers such as bentonite (a colloidal hydrated aluminum silicate), are used as protective coatings on various materials during processing steps. Once these processing steps have been completed the protective coating must be removed from the surface. Many of these greases, particularly those containing bentonite, are very difficult to remove with conventional solvents. Further, the solvents that do work reasonably well to remove such greases are very flammable and thus require very special handling and equipment to minimize hazards associated therewith.

Object of the invention is a method for removing petroleum based greases, especially such greases containing fillers, such as bentonite.

The object of the invention is achieved by a method which is characterized in that the grease is contacted with a solvent system consisting essentially of from 90% to 50% by weight of a solvent selected from the class of substituted and unsubstituted aromatic hydrocarbons and substituted and unsubstituted aliphatic hydrocarbons and from 10% to 50% by weight of an unsaturated fatty acid.

Preferably the solvent is a substituted aromatic, toluene being the preferred solvent. Preferably the unsaturated fatty acid

BU 980 027

is oleic acid, the preferred range of which is about 25% to about 35%, with preferred specific value being 30%.

As indicated above, petroleum based greases, particularly those containing fillers such as bentonite are used to protect selected surfaces of articles which articles are being processed in certain operations. One example of this need for protection is illustrated in the process for manufacturing semiconductor modules. During this process a substrate having a silicon semiconductor chip mounted thereon is epoxy bonded to a metal cap. During the dispense and subsequent cure cycles for the epoxy, it is necessary to protect the gold plated metal pins on the substrate from splattered epoxy. A very desirable material for affording such protection is a petroleum based grease having about 22% by weight of bentonite as a filler. Such a product is manufactured by Apiezon Products Limited, London, England, under the Trademark Apiezon H.

This bentonite filled grease serves the protection function well in that it protects the pins against splattered epoxy resin which could damage or interfere with the operation of the pins. However, once the curing is completed, the grease must be removed.

Many conventional solvents have little or no effect on removal of such grease, such as for example, acetone, isopropanol, benzyl alcohol, and hexane.

Other substituted alipathic hydrocarbons, such as methylene chloride, have only very moderate effects on the removal of such grease. Ethers, and benzene, have fair properties, while substituted aromatic compositions, such as xylene, nitro benzene, chlorobenzene, and aniline are moderately good at removal of such. Toluene is quite a good solvent for removing

BU 980 027

this grease. However, toluene and the other better solvents are extremely flammable and have a potential hazard requiring special handling and safeguards.

It has been found, according to the present invention, that the addition of from about 10% to about 50% by weight of an unsaturated fatty acid to any of the above solvents increases significantly the solvent's ability to dissolve and remove such grease;also the fatty acid lowers the flash point of the solvent system so created so as to substantially reduce any potential fire hazard.

As noted above, toluene is one of the better solvents for bentonite filled grease. To determine the effectiveness of toluene in such grease removal, a sample of 10 grams of toluene almost completely dissolved about 1.2 grams of Apiezon H grease, there being some small amount of precipitate indicating the solubility limit had been reached. However, 10 grams of a mixture of 70% toluene and 30% oleic acid by weight, completely dissolved 1.3 grams of Apiezon H grease with no evidence of precipitates indicating that the limit of solubility had not yet been reached. Thus, the addition of the oleic acid increased the solvent capability of this very good solvent. Further, and very significant, is the fact that the 70% toluene and 30% oleic acid system has an open cup flash point of 15°C while toluene alone has an open cup flash point of 4°C, thus providing a significant safety advantage for the oleic acid/toluene system.

It was unexpected that the addition of oleic acid would improve the solubility of the Apiezon H grease in toluene since oleic acid itself is a very poor solvent for such grease. In a test, 10 grams of oleic acid had only marginal effectiveness in dissolving 0.2 grams of Apiezon H grease. Hence, the addition

BU 980 027

- 4 -

of a very poor solvent to a fairly good solvent unexpectedly improves the solvent capability of the good solvent. It has further been found that the addition of an unsaturated fatty acid to all of the above noted hydrocarbon solvents improves their ability to dissolve this petroleum based grease.

Table I below lists various solvents and mixtures used to dissolve Apiezon H grease. In all cases 10 grams of the solvent system (30% oleic acid and 70% solvent) was used to dissolve the grease. Various amounts of grease were used for the different systems. The greater the ability of the system to dissolve grease, the greater amount of grease used in the tests. The solvent systems are ranked in increasing order of effectiveness, i. e., those at the top of the Table being the least effective solvent or solvent system, and those at the bottom of the Table being the most effective.

## T A B L E   I

| SOLVENT SYSTEM | GREASE (Gms) | Effect |
|---|---|---|
| Acetone | 0.1 | None |
| Isopropanol | 0.1 | None |
| Benzyl Alcohol | 0.2 | None |
| Hexane | 0.1 | Very slight reaction. |
| Oleic Acid | 0.1 | Very slight reaction. |
| Acetone/Oleic Acid | 0.1 | Slight reaction. |
| Methylene Chloride | 0.1 | Limited reaction. |
| Isopropanol/Oleic Acid | 0.2 | Limited reaction. |
| Isopropanol/Lauric Acid | 0.2 | Limited reaction. |
| Benzyl Alcohol/Oleic Acid | 0.2 | Limited reaction. |
| Cyclohexane/Oleic Acid | 0.1 | Totally dissolved some ppt.[1] |
| Methylene Chloride/Oleic Acid | 0.1 | Totally dissolved. |
| Cyclohexane | 0.1 | Totally dissolved. |
| Hexane/Oleic Acid | 0.2 | Almost totally dissolved. |
| Xylene/Lauric Acid | 0.3 | Totally dissolved some ppt. |
| Toluene/Lauric Acid | 0.3 | Totally dissolved some ppt. |
| Chlorobenzene/Lauric Acid | 0.3 | Totally dissolved some ppt. |
| Benzene | 0.3 | Totally dissolved. |
| Ether | 0.3 | Totally dissloved. |
| Nitrobenzene/Lauric Acid | 0.6 | Some undissolved grease. |
| Xylene | 0.6 | Some undissolved grease. |
| Aniline | 0.6 | Some undissolved grease. |
| Aniline/Oleic Acid | 0.6 | Some undissolved grease. |
| Nitrobenzene | 0.6 | Totally dissolved. |
| Chlorobenzene | 0.6 | Totally dissolved. |
| Nitrobenzene/Oleic Acid | 0.1 | Some undissolved grease. |
| Xylene/Oleic Acid | 0.2 | Almost totally dissolved. |
| Chlorobenzene/Oleic Acid | 0.2 | Totally dissolved some ppt. |
| Toluene | 0.2 | Totally dissolved some ppt. |
| Toluene/Oleic Acid | 0.3 | Totally dissolved. |

[1] ppt. - abbreviation for "precipitate".

In the tests it should be noted that the first three solvents, i. e., acetone, isopropanol, and benzyl alcohol had no effect at all in dissolving grease. Thus, aliphatic oxy and hydroxy hydrocarbons are essentially ineffective as solvents for bentonite filled petroleum based greases. Hexane and methylene chloride are a little more effective, but not really very good as solvents. Benzene and ether are better but still only moderately good as solvents, the only really effective hydrocarbon solvents being the substituted aromatic hydrocarbons, such as, xylene, aniline, chlorobenzene and toluene, with toluene being the best. However, it should be noted from Table I that in every case the ability of a given hydrocarbon solvent to dissolve the Apiezon H grease is increased by the addition of oleic acid which is an unsaturated fatty acid. Even the non-solvents, acetone, benzyl alcohol, and isopropanol, become mildly effective as solvents for this grease when oleic acid is added.

The addition of lauric acid, a saturated fatty acid, is somewhat anomalous, however. When lauric acid is added to the non-solvents, such as, acetone, benzyl alcohol, and isopropanol, and the very weak solvents such as methylene chloride, it does improve their solubility somewhat. However, when lauric acid is added to the better solvents, such as xylene, toluene, chlorobenzene and nitrobenzene, it significantly and substantially reduces their ability to dissolve this grease. The reason for this is not completely understood. However, it is believed that the unsaturated fatty acid provides a chelating or emulsifying effect especially for the bentonite, but also for the grease, thus contributing to improve solvency of the grease whereas the lauric acid does not contribute such an effect but only lends its limited ability to dissolve grease to the system. Nevertheless, whatever the reason, the unsaturated oleic acid improves the ability of every hydrocarbon solvent to dissolve this grease.

BU 980 027

0052786

- 7 -

It has been found that other unsaturated fatty acids also provide increased solubility of greases, such as, Apiezon H in hydrocarbon solvents. Mixtures of 30% linoleic acid, with isopropanol, with aniline, with chlorobenzene, and with toluene, as well as, 30% linolenic acid with isopropanol, with aniline, with chlorobenzene and with toluene were compared to a mixture of 30% oleic acid with isopropanol, with aniline, with chlorobenzene and with toluene for dissolving of Apiezon H grease. In each case, both the linoleic acid system and linolenic acid systems were comparable to the oleic acid systems, thus indicating the usefulness of unsaturated fatty acids generally. However, as can be seen from Table I, and as noted above, solvent systems utilizing saturated fatty acids as exemplified by lauric acid are not acceptable, and the addition of a saturated fatty acid actually reduces the effectiveness of the better solvents, such as, toluene, xylene, nitrobenzene and chlorobenzene.

With respect to the ranges of solvent and acid it has been found that a minimal effect of the acid is experienced with less than about 10% present while if more than about 50% is present, it is counter-productive and actually starts to reduce the amount of grease which can be dissolved. Hence, the range of about 10% to about 50% unsaturated fatty acid.

There are several ways to utilize the solvent system. The simplest method is to merely immerse the part to be degreased in a container of the solvent. Agitation, either mechanical or ultrasonic may be applied. Alternatively the solution can be sprayed onto the part to be degreased. The particular method of application is not critical.

What is claimed is:

BU 980 027

- 8 -

C L A I M S

1. Method of removing petroleum based grease from a part, characterized in that the grease is contacted with a solvent system consisting essentially of from 90% to 50% by weight of a solvent selected from the class of substituted and unsubstituted aromatic hydrocarbons and substituted and unsubstituted aliphatic hydrocarbons and from 10% to 50% by weight of an unsaturated fatty acid.

2. Method of claim 1, characterized in that there is from 75% to 65% of said solvent and from 25% to 35% of said unsaturated fatty acid.

3. Method of claims 1 and 2, characterized in that there is 70% of said solvent and 30% of said unsaturated fatty acid.

4. Method of claims 1 to 3, characterized in that said fatty acid is selected from the group of oleic acid, linoleic acid, and linolenic acid.

5. Method of claim 4, characterized in that the unsaturated fatty acid is oleic acid.

6. Method of claim 1, characterized in that the solvent is selected from the class of toluene, xylene, chlorobenzene, nitrobenzene, and aniline.

BU 980 027

7. Method of one or several of the preceeding claims, characterized in that the solvent is toluene and the unsaturated fatty acid is oleic acid.

8. Method of claim 7, characterized in that there is from 75% to 65% toluene and from 25% to 35% oleic acid.

9. Method of claim 8, characterized in that there is 70% toluene and 30% oleic acid.

0052786

**EUROPEAN SEARCH REPORT**

European Patent Office

Application number

EP 81108982.0

| | DOCUMENTS CONSIDERED TO BE RELEVANT | | CLASSIFICATION OF THE APPLICATION (Int. Cl.³) |
|---|---|---|---|
| Category | Citation of document with indication, where appropriate, of relevant passages | Relevant to claim | |
| | AT – B – 283 079 (HENKEL & CIE., GMBH) <br> * Page 1; examples; claims * <br> --- | 1-5 | C 23 G 1/00 <br> C 23 G 1/02 <br> C 23 G 5/02 // <br> H 01 L 21/306 |
| | US – A – 4 060 496 (J.F.T. BERLINER) <br> * Examples; claims * <br> -- | 1,4,5 | C 11 D 1/00 |
| | CH – A – 400 422 (SCHWEIZERISCHE SODA-FABRIK) <br> * Totality * <br> ----- | 1,4,5 | |

**TECHNICAL FIELDS SEARCHED (Int. Cl.³)**

C 23 G

C 11 D

H 01 L

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

| X | The present search report has been drawn up for all claims | | |
|---|---|---|---|
| Place of search <br> VIENNA | Date of completion of the search <br> 16-02-1982 | Examiner <br> SLAMA | |

EPO Form 1503.1 06.78